**Europäisches Patentamt**

**European Patent Office**

**Office européen des brevets**

(19)

(11) Veröffentlichungsnummer: **0 008 070**
A1

(12)

# EUROPÄISCHE PATENTANMELDUNG

(21) Anmeldenummer: 79102748.5

(51) Int. Cl.³: **H 05 K 9/00,** H 02 G 3/08

(22) Anmeldetag: 01.08.79

(30) Priorität: 03.08.78 DE 7823224 U

(43) Veröffentlichungstag der Anmeldung: 20.02.80
Patentblatt 80/4

(84) Benannte Vertragsstaaten: **AT BE CH FR GB IT LU NL
SE**

(71) Anmelder: **Kurt Wolf & Co. KG, Langwiesenweg 67/73,
D-7547 Wildbad (DE)**

(72) Erfinder: **Wolf, Kurt, Ing. grad., Langwiesenweg 71,
D-7547 Wildbad (DE)**

(74) Vertreter: **Vogel, Georg, Auenweg 14, D-7141
Schwieberdingen (DE)**

(54) Gehäuse für ein Mehrfachfilter, insbesondere ein Mehrkanalfilter im UHF-Bereich.

(57) Die Erfindung betrifft ein Gehäuse für ein Mehrfachfilter, insbesondere ein Mehrkanalfilter im UHF-Bereich,
das aus einer Metallkappe (10) und einer Metallbodenplatte (11) zusammengesetzt ist. Dieses Gehäuse soll einen
eindeutig entkoppelten Einbau von mehreren Filtern ermöglichen und die Festlegung der Abstimmelemente für
die Filterkreise erleichtern. Dazu ist die Metallkappe (10)
durch einstückig angeformte Trennwände (33, 34 . . .) rasterartig in Schotten (57, 58 . . .) unterteilt, die in Längsrichtung der Metallkappe ausgerichtete Reihen bilden.
Die Anzahl der Reihen entspricht der Anzahl der Filter und
die Anzahl der Schotten in den Reihen der Anzahl der Filterkreise eines Filters. In jedem Schott ist an der Kappenoberseite eine Aufnahmehülse (63) mit erweiterter Aufnahme für einen Abstimmkondensator angeformt.

Firma
Kurt Wolf & Co. KG
Langwiesenweg 67/73

D-7547  W i l d b a d

- 1 -

Gehäuse für ein Mehrfachfilter, insbesondere
ein Mehrkanalfilter im UHF-Bereich

Die Erfindung betrifft ein Gehäuse für ein Mehrfachfilter, insbesondere ein Mehrkanalfilter im UHF-Bereich, das aus einer im Querschnitt etwa rechteckförmigen Metall-Kappe und einer die offene Seite dieser Metall-Kappe verschliessenden Metall-Bodenplatte besteht.

Derartige Mehrkanalfilter werden insbesondere bei Fernsehantennenanlagen benötigt, um die Empfangsverhältnisse ausgesuchter Kanäle zu verbessern. In dem UHF-Bereich kommt es auf eine gute Abschirmung der einzelnen Filter und auch auf eine vorgegebene Charakteristik der Filter an, die nur mit abstimmbaren Kreisen zu erreichen ist.

Der Aufbau eines derartigen Mehrfachfilters erfordert daher beachtliche Entkopplungsmaßnahmen und Abgleicharbeiten. Die einzelnen Kreise der Filter werden mittels Abschirmplatten bzw. Abschirmblechen gegeneinander entkoppelt, die in die Metall-Kappe eingelötet werden. Für die Befestigung der abstimmbaren Kondensatoren, die vorzugsweise als Röhrchenkondensatoren ausgebildet sind, müssen besondere Trägerplatten oder dgl. vorgesehen werden, die zudem noch in der Metall-Kappe festgelegt werden müssen.

Es ist Aufgabe der Erfindung, ein Gehäuse für ein Mehrfachfilter der eingangs erwähnten Art zu schaffen, das schon vom Aufbau her einen eindeutig entkoppelten Einbau von mehreren Filtern ermöglicht und abei zusätzlich den Einbau und die Festlegung der für den Abgleich der Filterkreise erforderlichen abstimmbaren Kondensatoren erleichtert.

Dies wird erfindungsgemäß dadurch erreicht, daß die Kappe als Metallgußteil, vorzugsweise Metallspritzgußteil, ausgebildet ist, in dem mittels einstückig angeformter Längstrennwände und Quertrennwände Schotten abgeteilt sind, daß diese Schotten in Längsrichtung der Kappe in Reihen angeordnet sind, wobei die Anzahl der Reihen der Anzahl der Filter und die Anzahl der Schotten in den Reihen der Anzahl der abstimmbaren Kreise eines Filters entsprechen, und daß an der Deckplatte der Kappe in jedem Schott eine Aufnahmehülse für einen abstimmbaren Röhrchenkondensator einstückig angeformt ist, die beidseitig über die Deckplatte vorsteht und zur Innenseite hin eine im Durchmesser vergrößerte Aufnahme aufweist. Die so ausgebildete Kappe gibt den Einbau der einzelnen Filter mit den dafür erforderlichen abstimmbaren Kreisen fest vor, wobei die Schottenanordnung eine eindeutige Entkopplung der Filter untereinander und der Kreise innerhalb eines Filters sicherstellt. Außerdem sind durch die angeformten Aufnahmehülsen die Befestigungsstellen der abstimmbaren Kondensatoren schon vorgegeben, so daß diese leicht mit der Kappe verbunden, z.B. verlötet, werden können. Dabei bringen die Längs- und Quertrennwände sowie die Aufnahmehülsen für die Röhrchenkondensatoren bei der Herstellung der Kappe keine Schwierigkeiten, da sie in einem Arbeitsgang mit der Kappe hergestellt werden können. Der Aufbau des Mehrfachfilters ist dadurch jedoch so vereinfacht und erleichtert, daß der Einbau und Abgleich der elektrischen Filterbauteile keinerlei Schwierigkeiten mehr bereitet. Das Mehrfachfilter dieser Art ist daher auch sehr preisgünstig herstellbar.

Die Verdrahtung der Filter wird dadurch erleichtert, daß die Längstrennwände und die Quertrennwände im Bereich ihrer freien Kanten mit Aussparungen zur Durchführung von Verbindungskabeln zwischen benachbarten Schotten der gleichen bzw. der benachbarten Reihe versehen sind.

Der Einbau der Röhrchenkondensatoren in die Aufnahmehülsen kann dadurch ohne großen Platzbedarf im Innenraum der Kappe erfolgen, daß die Aufnahmehülse als Kragen mit der im Durchmesser vergrößerten Aufnahme an der Innenseite der Deckplatte absteht, während der Teil mit der kleineren Bohrung als erhöhter Kragen an der Außenseite der Deckplatte vorsteht.

Eine ausreichende Steifigkeit der Trennwände bei kleiner Stärke läßt sich nach einer Ausgestaltung dadurch erreichen, daß zumindst die Längstrennwände mittels im Querschnitt runder Pfeiler versteift sind.

A3706 — 4 — 0008070

Nach einer Weiterbildung ist vorgesehen, daß jede Reihe zwei Eingangsschotten und ein Ausgangsschott aufweist und daß zwischen den Eingangsschotten und dem Ausgangsschott jeweils ein Schott zur Aufnahme eines einstellbaren Dämpfungsgliedes vorgesehen ist, wobei in jedem dieser Schotten an dem kastenförmig hochgezogenen Deckplattenbereich eine Aufnahmehülse für ein Einstellglied des Dämpfungsgliedes einstückig angeformt ist. Damit läßt sich jedes Filter mit einem einstellbaren Dämpfungsglied versehen und daher individuell einstellen. Auf diese Weise lassen sich die Empfangspegel der ausgesuchten Kanäle am Eingang des Empfangsgerätes unabhängig von den von der Antenne gelieferten Kanalpegel auf gleiche Werte einstellen.

Ein ausreichend großer Raum für die Unterbringung der Dämpfungsglieder wird dabei dadurch geschaffen, daß der hochgezogene Deckplattenbereich sich über die Breite der Kappe erstreckt und etwa bündig mit den an der Außenseite der Deckplatte angeformten Kragen der Aufnahmehülsen abschließt.

Damit die Bodenplatte leicht und dicht mit der Kappe verbunden werden kann, sieht eine Ausgestaltung vor, daß an zwei einander diagonal gegenüberliegenden Ecken auf der Innenseite derKappe Schraubhülsen angeformt sind, die mit Gewindelöchern versehen sind und die wie die freien Kanten der Längstrennwände und der Quertrennwände in vorgegebenem Abstand zu den freien Kanten der Seitenwände der Kappe enden. Der Abstand entspricht dabei der Stärke der Bodenplatte.

Für die Befestigung des Mehrfachfilters an einer Wand ist nach einer Ausgestaltung vorgesehen, daß an den beiden verbleibenden Ecken der Kappe Befestigungshülsen mit Durch-

A 3706 — 5 — 0008070

gangsbohrungen angeformt sind, welche sich - von den freien Kanten der Seitenwände der Kappe ausgehend - nur über einen Teil der Höhe der Kappe erstrecken.

Das Verschließen der Kappe mit der Bodenplatte wird dadurch noch erleichtert, daß die Seitenwände derKappe vorzugsweise in der Mitte ihrer freien Kanten angeformte Zentrieransätze aufweisen, die in entsprechende Aussparungen der Bodenplatte eingreifen. Die Bodenplatte kann daher nur in der richtigen Stellung auf die offene Seite der Kappe aufgesetzt werden.

Damit die Einstellglieder für die Dämpfungsglieder nicht über die kastenförmige Erhöhung der Deckplatte der Kappe vorstehen, ist die Ausgestaltung so vorgenommen, daß die Aufnahmehülsen für die Einstellglieder der Dämpfungsglieder nur als Wulst an der Außenseite der kastenförmigen Erhöhung der Deckplatte vorstehen und mit dem weitaus größten Teil in die von der kastenförmigen Erhöhung und der Längstrennwände und Quertrennwände gebildeten, vertieften Schotten ragen.

Das Einführen der Einstellglieder in die zugeordneten Aufnahmehülsen wird dadurch erleichtert, daß sich die Bohrungen der Aufnahmehülsen für die Stellglieder der Dämpfungsglieder zu den Schotten hin konisch erweitern.

Für einen eindeutigen abgeschirmten Abschluß der offenen Seite der Kappe und eine ebene Anlagefläche des geschlossenen Gehäuses ist die Auslegung weiterhin so, daß die Befestigungshülsen mit Auflageabsätzen versehen sind, die mit den Enden der Schraubhülsen und den freien Kanten der Längstrennwände und der Quertrennwände in einer Ebene angeordnet sind und daß die Befestigungshülsen und die Zentrieransätze in einer Ebene enden, die in vorgegebenem Abstand von den freien Kanten der Seitenwände der Kappe liegt.

Die Erfindung wird anhand eines in den Zeichnungen dargestellten Ausführungsbeispiels näher erläutert. Es zeigen:

Fig. 1     die als Metallspritzgußteil ausgebildete Kappe des erfindungsgemäßen Gehäuses in die offene Seite gesehen, wobei die Trennwände deutliche erkennbar sind und

Fig. 2     einen Schnitt durch die Kappe, entlang der Linie II-II der Fig. 1, dem die angeformten Aufnahmehülsen für die Röhrchenkondensatoren und für die Einstellglieder der Dämpfungsglieder sowie die angeformten Schraub- und Befestigungshülsen zu entnehmen sind.

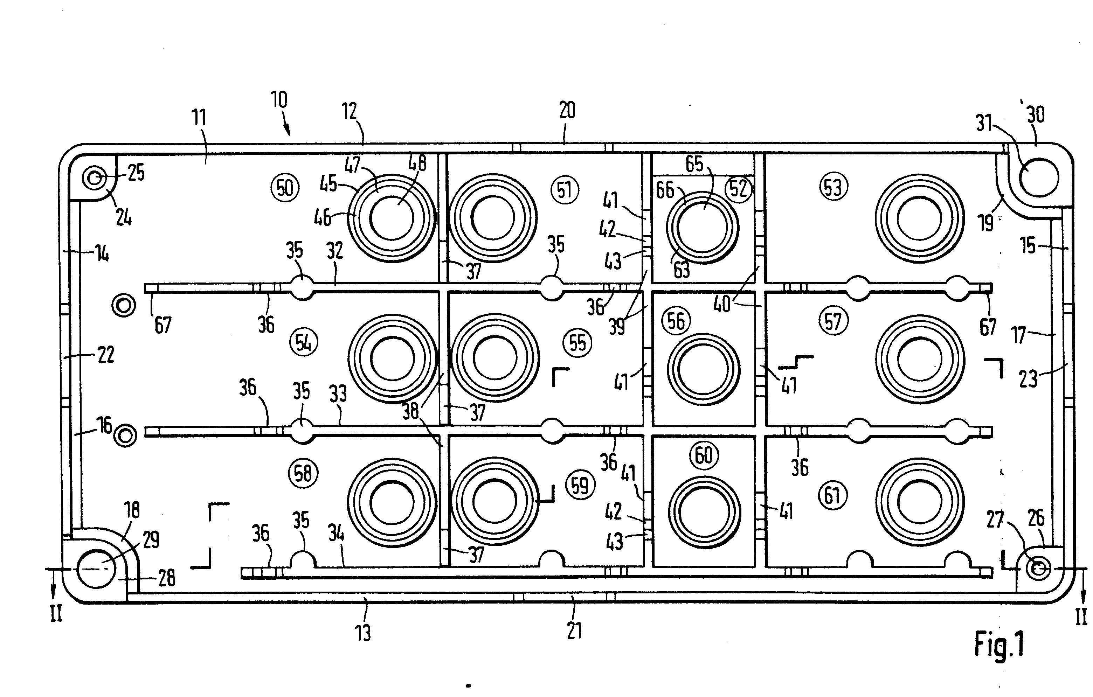

Die in den Fig. 1 in Ansicht und im Schnitt gezeigte Kappe 10 ist im Metallspritzgießverfahren hergestellt. Die boxartige Kappe 10 mit etwa rechteckigem Querschnitt umfaßt die Deckplatte 11 mit den Seitenwänden 12,13,14 und 15. An der Innenseite der Deckplatte 11 sind einstückig die Längstrennwände 32, 33 und 34, sowie die Quertrennwände 38, 39 und 40 angeformt. Diese Längstrennwände und Quertrennwände unterteilen den Innenraum der Kappe 10 in die Schotten 50 bis 61.

Diese Schotten sind in Reihen angeordnet, welche in die Längsrichtung der Kappe 10 ausgerichtet sind. Die Anzahl der Reihen entspricht der Anzahl der einzubauenden Filter. Das Gehäuse nach dem Ausführungsbeispiel ist mit seinen drei Reihen von Schotten daher für den Einbau eines Dreifachfilters geeignet. Das erste Filter belegt die Schotten 50 bis 53, das zweite Filter die Schotten 54 bis 57 und das dritte Filter die Schotten 58 bis 61.

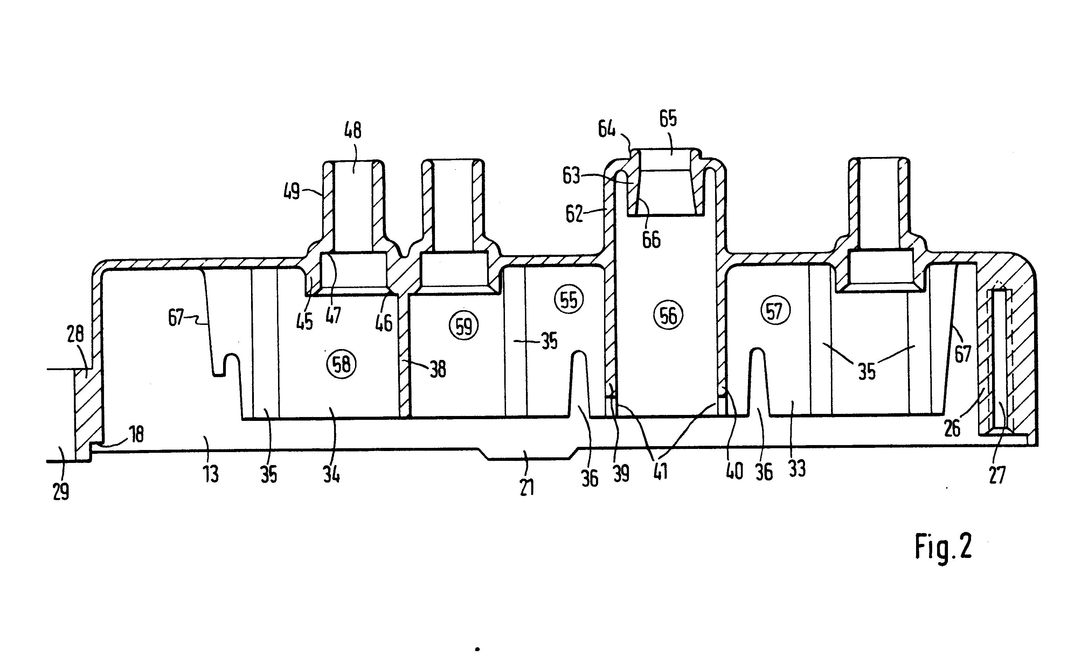

Die Anzahl der Schotten in einer Reihe ist durch die Anzahl der abstimmbaren Kreise in einem Filter gegeben. Umfaßt das Filter zwei Eingangskreise und einen Ausgangskreis, dann sind pro Reihe drei Schotten 51, 51 und 53 bzw. 54,55 und 57 bzw. 58,59 und 61 erforderlich. In jedem dieser Schotten muß ein abstimmbarer Röhrchenkondensator untergebracht werden. Daher ist an der Deckplatte 11 in jedem dieser Schotten eine Aufnahmehülse einstückig angeformt, in der ein Röhrchenkondensator festgelegt, d.h. eingelötet werden kann. Wie besonders dem Schnitt nach Fig. 2 zu entnehmen ist, hat die Aufnahmehülse eine gegenüber ihrer Bohrung 48 im Durchmesser vergrößerte Aufnahme 47, von der der Bund des Röhrchenkondensators aufgenommen wird. Die Aufnahmehülsen ragen mit einem niedrigen Kragen 45 mit der vergrößerten Aufnahme 47 in den Innenraum der Kappe 10, während der wesentlich höhere Kragen 49 mit der Bohrung 48 an der Außenseite der Deckplatte 11 vorsteht. Der Kragen 45 ist mit einer konisch erweiterten Einführöffnung 46 zur Aufnahme 47 versehen.

Da die Empfangspegel der ausgesuchten Kanäle einer UHF-Antennenanlage verschieden groß sind, muß eine individuelle Pegeleinstellmöglichkeit geschaffen werden. Dazu wird jedem Kanalfilter ein einstellbares Dämpfungsglied zugeordnet. Aus diesem Grund wird bei jedem Filter zwischen den beiden Eingangskreisen und dem Ausgangskreis ein einstellbares Dämpfungsglied eingeschaltet. Die Längstrennwände 32,33 und 34 und die Quertrennwände 38,39 und 40 bilden daher in den drei Reihen die zusätzlichen Schotten 52, 56 und 60, die diese Dämpfungsglieder abgeschirmt aufnehmen. Ihre räumliche Anordnung ist so, daß sie jeweils zwischen dem letzten Eingangskreis, d.h. dem Schott 51 bzw. 55 bzw. 59, und dem Ausgangskreis, d.h. dem Schott 53 bzw. 57 bzw. 60 liegen.

Die Längstrennwände 32,33,34 und die Quertrennwände 38,39, 40 reichen nicht bis zu den freien Kanten der Seitenwände 12,13,14 und 15 der Kappe 10, sondern enden in einem vorgegebenen Abstand dazu.

Außerdem weisen die freien Kanten der Längs- und Quertrennwände schlitzförmige Aussparungen 36,37,41,43 auf, die Verbindungskabel zwischen den benachbarten Schotten von gleichen oder benachbarten Reihen aufnehmen. Die Aussparungen 41 und 43, die durch Stege 42 voneinander getrennt sind, verbinden dabei die Schotten 52, 56 und 60 für die Dämpfungsglieder mit den benachbarten Schotten 51 und 53 bzw. 55 und 57 bzw. 59 und 61 derselben Reihe, um das Dämpfungsglied mit dem vorgeschalteten letzten abstimmbaren Eingangskreis und mit dem nachgeschalteten abstimmbaren Ausgangskreis verbinden zu können. Die Aussparungen 37 verbinden jeweils die beiden Schotten 50 und 51 bzw. 54 und 55 bzw. 58 und 59 für die Eingangskreise eines Filters. Schließlich ermöglichen die Aussparungen 36 in den Längstrennwänden 32,33 und 34 Übergänge zwischen entsprechenden Schotten benachbarter Filter, z.B. vom Schott 50 zum Schott 54, vom Schott 54 zum Schott 58, vom Schott 51 zum Schott 55, vom Schott 55 zum Schott 59, vom Schott 53 zum Schott 57, und vom Schott 57 zum Schott 61. Die Längstrennwände 32,33 und 34 sind in den größeren Schotten mittels im Querschnitt runder Pfeiler 35 versteift.

Damit die Schotten in allen Reihen dieselben Verhältnisse bieten, wird die Seitenwand 13 der Kappe 10 nicht als Schottenwand ausgenützt, sondern die getrennte Längstrennwand 34 an der Deckplatte 11 angeformt. Lediglich die Seitenwand 12 der Kappe 10 wird als Schottenwand mitausgenützt.

Im Bereich der Schotten 52, 56 und 60 für die Dämpfungsglieder ist die Deckplatte 11 mit einer kastenförmigen Erhöhung 62 versehen, die über die Breite der Kappe 10 reicht. Auf diese Weise werden vertiefte Schotten 52, 56 und 60 geschaffen, die damit ausreichend Platz für die Aufnahme einstellbarer Dämpfungsglieder bieten. An der Erhöhung 62 sind Aufnahmehülsen 63 für die Einstellglieder der zugeordneten Dämpfungsglieder angeformt. Die Bohrungen 66 der Aufnahmehülsen 63 erweitern sich konisch zu den Schotten 52, 56 und 60 hin und erleichtern so das Einführen der Einstellglieder, die über die Bohrungen 65 der Aufnahmehülsen 63 zugänglich sind. Die Aufnahmehülsen 63 stehen nur als Wülste 65 über die Erhöhung 62 der Kappe 10 vor.

An zwei diagonal liegenden Ecken sind auf der Innenseite der Kappe 10 Schraubhülsen 24 und 26 mit Gewindelöchern 25 und 27 angeformt, die die Befestigungsschrauben für die (nicht gezeigte) Bodenplatte aufnehmen. Diese Schraubhülsen 24 und 26 sind gegenüber den freien Kanten der Seitenwände 12,13,14 und 15 der Kappe 10 um einen vorgegebenen Abstand zurückgesetzt. In den beiden restlichen Ecken der Kappe 10 sind Befestigungshülsen 28 und 30 mit Durchgangsbohrungen 29 und 31 angeformt, die sich nur über einen Teil der Höhe der Kappe 10 erstrecken. In der Mitte der freien Kanten der Seitenwände 12, 13, 14 und 15 sind Zentrieransätze 20, 21, 22 und 23 angeformt, die in Durchbrüche der Bodenplatte eingreifen. Diese Zentrieransätze 20, 21, 22 und 23 liegen mit den Befestigungshülsen 28 und 30 in einer Ebene, so daß die im Bereich der Befestigungshülsen 28 und 30 ausgesparte Bodenplatte bündig mit dieser Ebene mit der Kappe 10 verbunden werden kann. Auf diese Weise bildet das Gehäuse eine absolut ebene Befestigungsfläche. Die Befestigungshülsen 28 und 30 haben Auflageabsätze 18 und 19, die, wie die Schraubhülsen 24 und 26 die Bodenplatte stützen. Auch die Seitenwände 14 und 15 können auf der Innenseite entsprechende Absätze 16 und 17 aufweisen. Die Ausgestaltung ist dabei vorzugsweise so, daß sich die Bodenplatte auf den Auflageabsätzen 18 und 19 der Befestigungshülsen 28 und 30, den Schraubhülsen 24 und 26, den Absätzen 16 und 17 und auch den freien Kanten der Längstrennwände 32, 33 und 34 sowie der Quertrennwände 38, 39 und 40 abstützt. Die Bodenplatte kann dann bei entsprechend abgestimmter Stärke die offenen Seiten der Schotten 50 bis 61 vollständig geschirmt verschließen.

Ansprüche :

1. Gehäuse für ein Mehrfachfilter, insbesondere ein Mehrkanalfilter im UHF-Bereich, bestehend aus einer im Querschnitt etwa rechteckförmigen Metall-Kappe und einer die offene Seite dieser Metall-Kappe verschließenden Metall-Bodenplatte, dadurch gekennzeichnet, daß die Kappe (10) als Metallgußteil, vorzugsweise Metallspritzgußteil, ausgebildet ist, in dem mittels einstückig angeformter Längstrennwände (32,33,34) und Quertrennwände (38,39,40) Schotten (50,51,52,53,54, 55,57,58,59,61) abgeteilt sind, daß diese Schotten in Längsrichtung der Kappe (10) in Reihen angeordnet sind, wobei die Anzahl der Reihen der Anzahl der Filter und die Anzahl der Schotten in den Reihen der Anzahl der abstimmbaren Kreise eines Filters entsprechen, und daß an der Deckplatte (11) der Kappe (10) in jedem Schott eine Aufnahmehülse für einen abstimmbaren Röhrchenkondensator einstückig angeformt ist, die beidseitig über die Deckplatte (11) vorsteht und zur Innenseite hin eine im Durchmesser vergrößerte Aufnahme (47) aufweist.

2. Gehäuse nach Anspruch 1, dadurch gekennzeichnet, daß die Längstrennwände (32,33,34) und die Quertrennwände (38,39,40) im Bereich ihrer freien Kanten mit Aussparungen (36,37,41,43) zur Durchführung von Verbindungskabeln zwischen benachbarten Schotten der gleichen bzw. der benachbarten Reihe versehen sind.

A 3706 — 2 — 0008070

3. Gehäuse nach Anspruch 1 und 2,
dadurch gekennzeichnet,
daß die Aufnahmehülse als Kragen (45) mit der im
Durchmesser vergrößerten Aufnahme (47) an der Innenseite der Deckplatte (11) absteht, während der Teil
mit der kleineren Bohrung (48) als erhöhter Kragen
(49) an der Außenseite der Deckplatte (11) vorsteht.

4. Gehäuse nach einem der Ansprüche 1 bis 3,
dadurch gekennzeichnet,
daß zumindest die Längstrennwände (32,33,34) mittels
im Querschnitt runder Pfeiler (35) versteift sind.

5. Gehäuse nach einem der Ansprüche 1 bis 4,
dadurch gekennzeichnet,
daß jede Reihe zwei Eingangsschotten (50,51 bzw. 54,
55 bzw. 58,59) und ein Ausgangsschott (53 bzw. 57
bzw. 61) aufweist und daß zwischen den Eingangsschotten und dem Ausgangsschott jeweils ein Schott (52,56,
60) zur Aufnahme eines einstellbaren Dämpfungsgliedes
vorgesehen ist, wobei in jedem dieser Schotten (52,
56,60) an dem kastenförmig hochgezogenen Deckplattenbereich (62) eine Aufnahmehülse (63) für ein Einstellglied des Dämpfungsgliedes einstückig angeformt ist.

6. Gehäuse nach Anspruch 5,
dadurch gekennzeichnet,
daß der hochgezogene Deckplattenbereich (62) sich
über die Breite der Kappe (10) erstreckt und etwa
bündig mit den an der Außenseite der Deckplatte (11)
angeformten Kragen (49) der Aufnahmehülsen abschließt.

A 3706 - 3 - 0008070

7. Gehäuse nach einem der Ansprüche 1 bis 6,
dadurch gekennzeichnet,
daß an zwei einander diagonal gegenüberliegenden
Ecken auf der Innenseite der Kappe (10) Schraubhülsen (24,26) angeformt sind, die mit Gewindelöchern (25,27) versehen sind und die wie die
freien Kanten der Längstrennwände (32,33,34) und
der Quertrennwände (38,39,40) in vorgegebenem Abstand zu den freien Kanten der Seitenwände (12,13,
14,15) der Kappe (10) enden.

8. Gehäuse nach Anspruch 7,
dadurch gekennzeichnet,
daß der Abstand der Stärke der Bodenplatte entspricht.

9. Gehäuse nach Anspruch 7 und 8,
dadurch gekennzeichnet,
daß an den beiden verbleibenden Ecken der Kappe (10)
Befestigungshülsen (28,30) mit Durchgangsbohrungen
(29,31) angeformt sind, welche sich - von den freien
Kanten der Seitenwände (12,13,14,15) der Kappe (10)
ausgehend - nur über einen Teil der Höhe der Kappe
(10) erstrecken.

10. Gehäuse nach Anspruch 7 bis 9,
dadurch gekennzeichnet,
daß die Seitenwände (12,13,14,15) der Kappe (10)
vorzugsweise in der Mitte ihrer freien Kanten angeformte Zentrieransätze (20,21,22,23) aufweisen,
die in entsprechende Aussparungen der Bodenplatte
eingreifen.

11.  Gehäuse nach Anspruch 5 und 6,
     dadurch gekennzeichnet,
     daß die Aufnahmehülsen (63) für die Einstellglieder der Dämpfungsglieder nur als Wulst (64) an der
     Außenseite der kastenförmigen Erhöhung (62) der
     Deckplatte (11) vorstehen und und mit dem weitaus
     größten Teil in die von der kastenförmigen Erhöhung
     (62) und der Längstrennwände (32,33,34) und Quertrennwände (38,39,40) gebildeten, vertieften Schotten (52,56,60) ragen.

12.  Gehäuse nach Anspruch 11,
     dadurch gekennzeichnet,
     daß sich die Bohrungen (66) der Aufnahmehülsen (63)
     für die Stellglieder der Dämpfungsglieder zu den
     Schotten (52,56,60) hin konisch erweitern.

13.  Gehäuse nach Anspruch 9,
     dadurch gekennzeichnet,
     daß die Befestigungshülsen (28,30) mit Auflageabsätzen (18,19) versehen sind, die mit den Enden der
     Schraubhülsen (24,26) und den freien Kanten der Längstrennwände (32,33,34) und der Quertrennwände (38,39,
     40) in einer Ebene angeordnet sind.

14.  Gehäuse nach Anspruch 9 und 10,
     dadurch gekennzeichnet,
     daß die Befestigungshülsen (28,30) und die Zentrier-
     ansätze (20,21,22,23) in einer Ebene enden, die in
     vorgegebenem Abstand von den freien Kanten der Seitenwände (12,13,14,15) der Kappe (10) liegt.

15. Gehäuse nach einem der Ansprüche 1 bis 14,
dadurch gekennzeichnet,
daß die Schotten (50 bis 61) in der Längsrichtung
stets durch Längstrennwände (32,33,34) gebildet sind
und daß nur eine Seitenwand (z.B. 12) der Kappe (10)
als Schottenwand mit ausgenützt ist.

Fig.1

0008070

1/2

Fig.2

0008070

## EINSCHLÄGIGE DOKUMENTE

| Kategorie | Kennzeichnung des Dokuments mit Angabe, soweit erforderlich, der maßgeblichen Teile | betrifft Anspruch |
|---|---|---|
| A | <u>US - A - 2 994 844</u> (MOTOROLA)<br>* Ansprüche; Figur 6 *<br>-- | 1 |
| A | <u>FR - A - 868 637</u> (C. LORENZ A.G.)<br>* Ansprüche; Seite 2, Zeilen 12-16; Figur 1 *<br>-- | 1,4 |
| A | <u>US - A - 3 002 044</u> (R.R. SCOVILLE)<br>* Ansprüche; Figur 2; Seite 1, Spalte 2, Zeilen 59-69 *<br>-- | 1,7,9 |
| A | <u>US - A - 4 065 020</u> (CARSON IND.)<br>* Ansprüche; Figur 6 *<br>-- | 1,14 |
| P | <u>DE - A - 2 806 186</u> (SOC. ITALIANA TELECOM. SIEMENS S.p.A.)<br>* Ansprüche; Figur 2 *<br>---- | 1,2,4 |

**KLASSIFIKATION DER ANMELDUNG (Int.Cl. 3)**

H 05 K 9/00
H 02 G 3/08

**RECHERCHIERTE SACHGEBIETE (Int. Cl. 3)**

H 05 K 9/00
       5/04
       5/03
H 02 B 1/08
H 02 G 3/08

**KATEGORIE DER GENANNTEN DOKUMENTE**

X: von besonderer Bedeutung

A: technologischer Hintergrund

O: nichtschriftliche Offenbarung

P: Zwischenliteratur

T: der Erfindung zugrunde liegende Theorien oder Grundsätze

E: kollidierende Anmeldung

D: in der Anmeldung angeführtes Dokument

L: aus andern Gründen angeführtes Dokument

&: Mitglied der gleichen Patentfamilie, übereinstimmendes Dokument

Der vorliegende Recherchenbericht wurde für alle Patentansprüche erstellt.

| Recherchenort | Abschlußdatum der Recherche | Prüfer |
|---|---|---|
| Den Haag | 09-11-1979 | VAN REETH |